# DEMANDE DE BREVET EUROPEEN

(11) **EP 2 369 618 A1**
(43) Date de publication de la demande: **28.09.2011**
(21) Numéro de dépôt: 11354010.8
(22) Date de dépôt: 24.03.2011
(51) Int. Cl.: H01L 21/8244, H01L 27/11, G11C 11/412, H01L 27/02

(54) **Cellule memoire sram a quatre transistors munis d'une contre-electrode**

(30) Priorité: 26.03.2010 FR 1001214
(71) Demandeur: Commissariat à l'Énergie Atomique et aux Énergies Alternatives, 75015 Paris (FR); STMicroelectronics "Crolles 2" S.A.S., 38926 Crolles (FR)
(72) Inventeur: Thomas, Olivier, 38420 Revel (FR); Fenouillet-Béranger, Claire, 38400 Saint Martin d'Hères (FR); Coronel, Philippe, 38530 Barraux (FR); Denorme, Stéphane, 38920 Crolles (FR)
(74) Mandataire: Talbot, Alexandre

(57) **Abrégé**

La cellule mémoire est de type SRAM à quatre transistors munis d'une contre-électrode. Elle comporte une première zone en matériau semi-conducteur (5a) avec un premier transistor d'accès (1a) et un premier transistor de conduction (2a) connectés en série, leur borne commune définissant un premier noeud électrique (F). Un second transistor d'accès (1b) et un second transistor de conduction (2b) sont connectés en série sur une seconde zone en matériau semi-conducteur (5b) et leur borne commune définit un second noeud électrique (S). Le substrat de support comprend des première et seconde contre-électrodes. Les première et seconde contre-électrodes sont respectivement en vis-à-vis des première et seconde zones en matériau semi-conducteur (5). Le premier transistor d'accès (1a) et le second transistor de conduction (2b) sont d'un premier coté d'un plan (FS) passant par les premier (F) et second (S) noeuds électriques alors que le premier transistor de conduction (2a) et le second transistor d'accès (1 b) sont de l'autre coté plan (FS).

## Description

### Domaine technique de l'invention

L'invention est relative à une cellule mémoire de type SRAM à quatre transistors munis d'une contre-électrode.

### État de la technique

Depuis quelques années, les caractéristiques électriques des transistors sur substrat massif de silicium se sont dégradées avec l'accentuation des effets parasites liés à la réduction des dimensions. Ces modifications du comportement du transistor ont une grande influence sur le fonctionnement des cellules mémoires et rendent alors leur fonctionnement moins robuste. Dans le même temps, la cellule mémoire de type SRAM (« Static Random Acess Memory ») conventionnelle comportant six transistors (quatre de type NMOS et deux de type PMOS), occupe une surface trop importante dans les circuits intégrés. Afin de réduire l'importance de ces écueils, de nouvelles architectures voient le jour et doivent permettre la réalisation de cellules mémoires occupant moins de surface, tout en ayant un fonctionnement robuste.

Pour un noeud technologique donné, la réduction de surface de la cellule est principalement liée à la réduction du nombre de transistors. Aujourd'hui, de nombreuses cellules mémoires comportant seulement quatre ou cinq transistors sont proposées. Ces cellules sont généralement connectées à une ligne de mot et à deux lignes de bit.

Certaines architectures ont abouti à des cellules mémoires de type « loadless » où les transistors de charge ont été éliminés. Dans d'autres cas ce sont les deux transistors de conduction qui ont été supprimés et une cellule mémoire de type « driverless » est alors obtenue.

De façon générale, les cellules mémoires à quatre transistors ne sont pas suffisamment stables pour garantir un bon fonctionnement en tenant compte des variations du processus de fabrication. En particulier, la cellule mémoire SRAM de type « loadless » comportant quatre transistors est très sensible au décalage des performances électriques des transistors de la cellule et à l'augmentation de la température. Ces deux points entraînent, généralement, l'utilisation de circuits supplémentaires de compensation et réduisent alors, fortement, le gain de surface obtenu en éliminant des transistors de la cellule.

Cependant, l'utilisation de transistors à double grille dans une cellule mémoire de type SRAM à quatre transistors permet d'améliorer le comportement électrique et de rapprocher les performances de cette cellule à celles d'une cellule à six transistors. Une telle cellule mémoire est décrite dans le document US2009/0129142. Comme illustré à la figure 1, la cellule mémoire comporte deux transistors d'accès 1 a, 1b et deux transistors de conductions 2a, 2b. Les transistors d'accès 1 de type pMOS sont chacun connectés en série à un transistor de conduction 2 de type nMOS entre une ligne Bit BL, BLC et la masse GND. L'électrode de source/drain commune à un transistor d'accès et un transistor de conduction définit un noeud électrique 3a, 3b qui est connecté à l'électrode de grille du transistor de conduction opposé ainsi qu'aux contre-électrodes 4 des transistors d'accès et de conduction opposés.

De part ce montage électrique, il est possible d'obtenir une cellule mémoire à quatre transistors qui est plus compacte qu'une cellule mémoire à six transistors et qui présente des performances intéressantes.

Cependant, bien que le schéma électrique paraisse assez simple, la présence de quatre contre-électrodes au sein de la cellule mémoire rend cette cellule complexe à réaliser. Les transistors munis d'une contre-électrode sont des transistors de type silicium sur isolant dans lesquels le substrat de support comporte une zone fortement conductrice de l'électricité qui forme la contre-électrode.

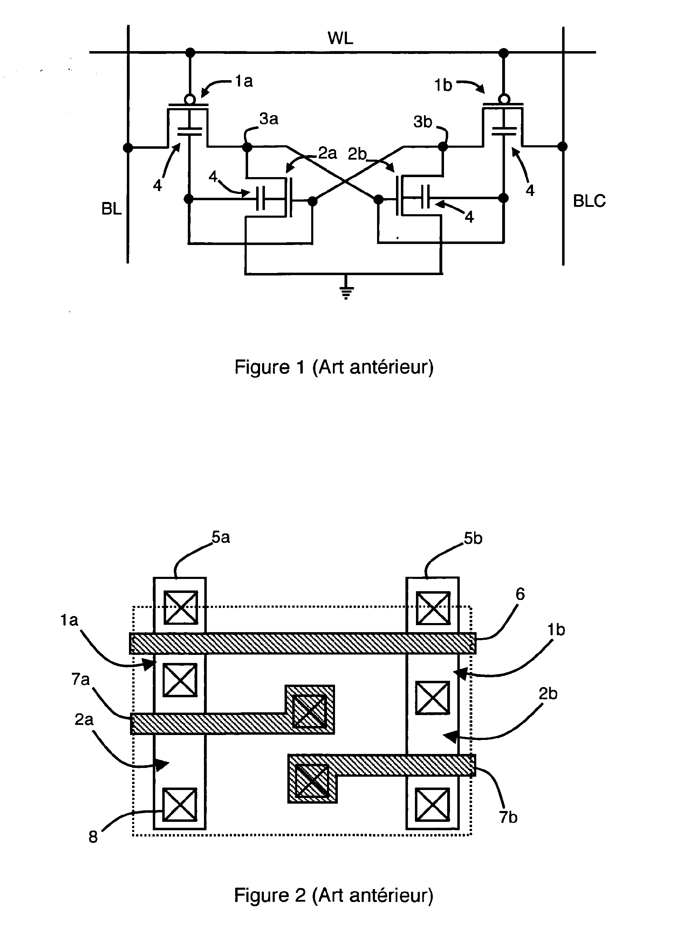

Comme illustré à la figure 2, la couche en silicium sur isolant est structurée afin de former deux zones actives 5a, 5b rectangulaires identiques qui se font faces. Sur chacune de ces zones actives 5, un transistor d'accès 1 et un transistor de conduction 2 sont intégrés afin d'être connectés en série. Les transistors d'accès 1 sont connectés sur la partie supérieure de la zone active 5 alors que les transistors de conduction 2 sont connectés sur la partie inférieure de la zone active 5 de la figure 2.

Une électrode de grille 6 commune est réalisée pour former les transistors d'accès 1. Deux électrodes de grilles 7a, 7b distinctes sont formées afin de définir les transistors de conduction 2. Des contacts électriques verticaux 8, des via conducteurs, sont formés sur les électrodes afin de permettre leur connexion électrique au moyen de niveaux d'interconnexions supérieurs (non représentés). Ces contacts 8 représentent schématiquement les électrodes de source/drain des transistors 1 et 2 des zones actives 5 et la zone de l'électrode de grille 7 qui est utilisée pour les connexions électriques.

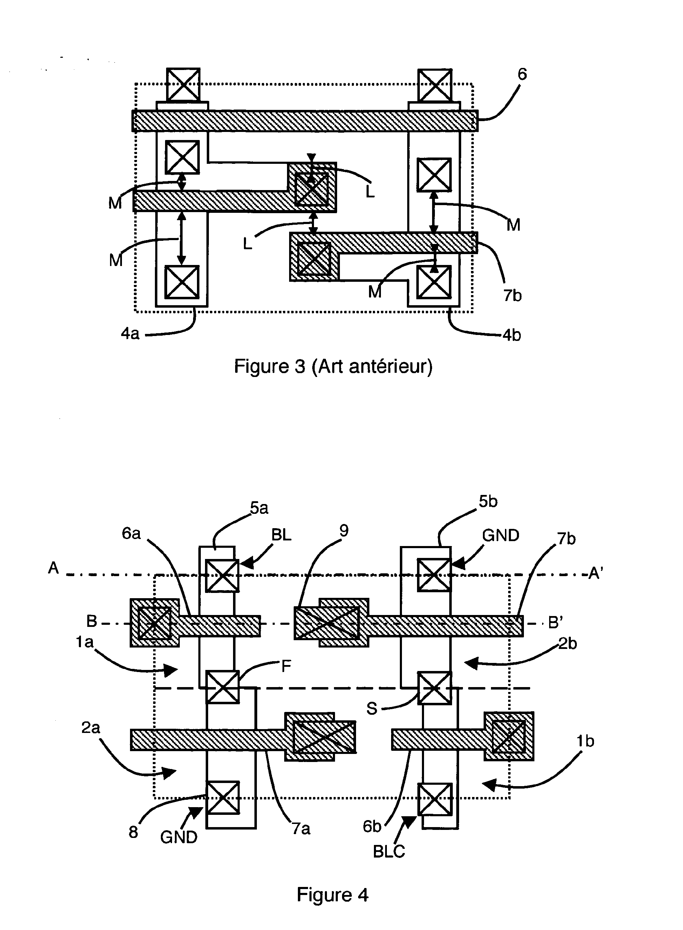

Comme illustré à la figure 3, les contre-électrodes 4 sont formées sous les zones actives 5 dans le substrat de support. Les contre-électrodes 4 présentent en plus du dessin de la zone active 5 rectangulaire, une excroissance qui s'étend sous l'électrode de grille 7 de manière à permettre la connexion électrique de l'électrode de grille 7 avec la contre-électrode 4.

Une fois les transistors réalisés, les contacts 8 de grille et de source/drain sont formés. Puis les niveaux d'interconnexions métalliques sont formés pour finaliser la cellule mémoire et obtenir les connexions électriques recherchées entre les différentes électrodes.

Cette cellule mémoire présente d'un point de vue électrique de nombreux avantages, mais sont fonctionnement reste imparfait et son mode de réalisation est difficile à rendre industriel.

### Résumé de l'invention

L'invention à pour objet une cellule mémoire plus compacte que la cellule mémoire de l'art antérieur sans augmenter la complexité du procédé de réalisation.

Pour satisfaire ce besoin, on prévoit notamment un dispositif selon les revendications annexées et en particulier un dispositif qui comporte :
- une première zone en matériau semi-conducteur avec un premier transistor d'accès et un premier transistor de conduction connectés en série, leur borne commune définissant un premier noeud électrique,
- une seconde zone en matériau semi-conducteur avec un second transistor d'accès et un second transistor de conduction connectés en série, leur borne commune définissant un second noeud électrique,
- un substrat de support, avec des première et seconde contre-électrodes, les première et seconde contre-électrodes étant respectivement en vis-à-vis des première et seconde zones en matériau semi-conducteur,
- le premier transistor d'accès et le second transistor de conduction sont d'un premier coté d'un plan passant par les premier et second noeuds électriques et en ce que le premier transistor de conduction et le second transistor d'accès sont de l'autre coté dudit plan,
- les connexions de la contre-électrode et de l'électrode de grille associée sont disposées de part et d'autre dudit plan.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1 représente, d'un point de vue électrique, une cellule mémoire avec quatre transistors à contre-électrodes selon l'art antérieur,
- les figures 2 et 3 représentent de manière schématique en vue de dessus, le dessin d'une cellule mémoire selon l'art antérieur au niveau de la couche en silicium sur isolant et au niveau du substrat de support,
- les figures 4 et 5 représentent de manière schématique, en vue de dessus, deux variantes du dessin d'une cellule mémoire au niveau de la couche en semi-conducteur sur isolant.

### Description d'un mode de réalisation préféré de l'invention

Comme illustré à la figure 4 la cellule mémoire de type SRAM comporte quatre transistors, deux transistors d'accès 1 a, 1b et deux transistors de conduction 2a, 2b. Un transistor d'accès 1 est connecté en série avec un transistor de conduction 2 entre une ligne de bit BL, BLC et une tension prédéterminée, telle la masse GND ou la tension d'alimentation de la cellule Vdd.

La cellule mémoire comporte donc deux paires de transistors connectés en série. Chacune de ces paires de transistors est formée sur une zone active 5, c'est-à-dire sur une zone en matériau semi-conducteur qui est électriquement isolée de l'autre zone active et du substrat de support. Les transistors d'accès 1 sont tous les deux connectés à une ligne de Bit BL, BLC et les transistors de conduction 2 sont tous les deux connectés à la masse GND ou à la tension Vdd par une de leurs électrodes de source/drain, par exemple, par l'intermédiaire d'un contact 8 de source/drain.

De cette manière, la première zone active 5a, par exemple, la zone active située à gauche sur la figure 4 comporte les premiers transistors d'accès 1a et de conduction 2a. Le premier transistor d'accès 1a est connecté en série avec le premier transistor de conduction 2a par l'intermédiaire de leurs électrodes de source et de drain. Ces deux transistors ont donc une électrode commune c'est-à-dire une partie du volume de la zone en matériau semi-conducteur qui forme un premier noeud électrique F. Ils ont avantageusement un contact 8 commun.

De manière analogue, la seconde zone active 5b, par exemple la zone active située à droite sur la figure 4 comporte les seconds transistors d'accès 1 b et de conduction 2b. Le second transistor d'accès 1b est connecté en série avec le second transistor de conduction 2b par l'intermédiaire de leurs électrodes de source et de drain. Ces deux transistors ont donc une électrode commune c'est-à-dire une partie du volume de la zone en matériau semi-conducteur qui forme un second noeud électrique S. Ils ont avantageusement un contact 8 commun.

Les transistors d'accès 1 sont d'un premier type de conductivité, par exemple des transistors pMOS, et les transistors de conduction 2 sont d'un second type de conductivité qui est opposé au premier type de conductivité, par exemple des transistors nMOS. Il est possible de changer la conductivité des transistors de conduction 2 et d'accès 1 dans la mesure où ils présentent des types de conductivité opposés.

Les transistors d'accès 1 et de conduction 2 sont de type semi-conducteur sur isolant avec une contre-électrode 4, ce qui signifie qu'ils sont réalisés sur un substrat qui comporte successivement un substrat de support, une couche en matériau d'isolation électrique, une couche en matériau semi-conducteur. Les première et seconde zones actives en matériau semi-conducteur 5 sont formées dans la couche en matériau semi-conducteur. Ces première et seconde zones actives 5 sont isolées électriquement l'une de l'autre par un motif d'isolation électrique qui les sépare. Ce motif d'isolation peut être réalisé par un matériau isolant électriquement, par exemple un oxyde de silicium ou un nitrure de silicium, ou par gravure d'une partie de la couche en matériau semi-conducteur de sorte qu'il n'y ait plus de contact électrique entre ces deux zones 5.

De cette manière, les premiers transistors d'accès 1 a et de conduction 2a partagent la même zone active, la première zone active 5a, c'est-à-dire le même volume de matériau semi-conducteur. Comme expliqué plus haut, ils partagent également une électrode de source/drain et, de préférence, le contact 8 associé, typiquement un via, un conducteur électrique orienté verticalement.

De manière analogue, les seconds transistors d'accès 1b et de conduction 2b partagent la même zone active, la seconde zone active 5b, c'est-à-dire le même volume de matériau semi-conducteur. Ils partagent également une électrode de source/drain et, de préférence, le contact 8 associé, typiquement un via.

La cellule mémoire comporte des première et seconde contre-électrodes 4. La première contre-électrode 4a est en vis-à-vis de la première zone active 5a et la seconde contre-électrode 4b est en vis-à-vis de la seconde zone active 5b. Le vis-à-vis entre une contre-électrode 4 et sa zone active 5 associée est vertical et ces deux éléments sont séparés par un matériau électriquement isolant. La première contre-électrode est commune aux premiers transistors d'accès et de conduction alors que la seconde contre-électrode est commune aux seconds transistors d'accès et de conduction.

Dans un mode de réalisation particulier qui permet d'obtenir une bonne compacité de la cellule mémoire, la première et avantageusement la seconde zones actives 5 présentent une forme allongée. La zone active 5 allongée est alors orientée selon un axe qui passe par les électrodes distinctes de source/drain des transistors d'accès et de conduction associés. Dans une variante de réalisation, les contacts de source/drain des transistors d'accès 1 et de conduction 2 d'une même zone active 5 sont alignés.

Les première 5a et seconde 5b zones actives sont parallèles, c'est-à-dire qu'elles ont des axes longitudinaux parallèles. L'axe longitudinal de la zone active 5 correspond à l'axe qui traverse le transistor d'accès 1 et le transistor de conduction 2 d'une même zone active 5. L'axe longitudinal correspond à l'axe qui passe par les contacts 8 de source/drain des deux transistors. C'est également un axe qui est avantageusement perpendiculaire à l'axe longitudinal des électrodes de grille déposées sur la zone active 5.

Dans un mode de réalisation particulier, il est envisageable de s'écarter de ce parallélisme des zones actives en acceptant un léger décalage.

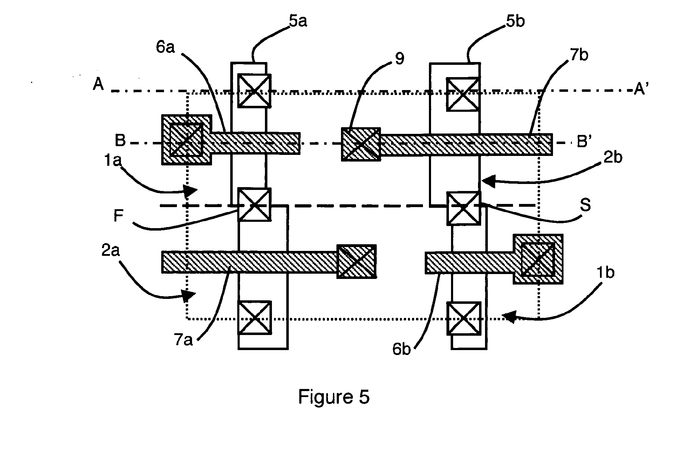

Dans une variante de réalisation illustrée aux figures 4 et 5, la largeur de la zone active 5 n'est pas constante le long de son axe longitudinal. Cependant, elle est constante ou sensiblement constante pour un transistor donné. Ainsi, il existe une différence de largeur de la zone active 5 entre le transistor d'accès 1 et le transistor de conduction 2. Cette différence de largeur de la zone active 5 permet de modifier la largeur effective du canal de conduction du transistor. De cette manière, il est possible de moduler les caractéristiques électriques du transistor d'accès 1 par rapport au transistor de conduction 2. Dans un mode de réalisation particulier, la zone active 5 présente une paroi longitudinale qui est plane alors que la paroi opposée présente un décroché, c'est-à-dire une marche. Dans un autre mode de réalisation, les deux parois longitudinales présentent chacune un décroché. Ce décroché permet, selon les règles de dessins utilisables, d'assurer une bonne connexion électrique entre la zone active et le contact métallique représentatif de l'électrode. Cependant, ce décroché induit une difficulté supplémentaire dans la gestion de l'étape de photolithographie liée au dessin de la zone active. Dans un cas, la zone active 5 présente une zone étroite (le transistor d'accès) comprise dans le prolongement d'une zone large (le transistor de conduction), de préférence avec un axe de symétrie longitudinal alors que dans l'autre cas, la partie la plus mince (le transistor d'accès) décroche de la partie la plus large (le transistor de conduction) comme cela est visible sur les figures 4 et 5.

Avantageusement, les première 5a et seconde 5b zones actives sont identiques du point de vue dimensionnel. Elles ont la même longueur, la même largeur et elles présentent les mêmes variations de largeur quand elles existent. Dans la mesure, où elles proviennent de la même couche en matériau semi-conducteur, les deux zones actives 5 présentent également la même épaisseur. Il est considéré que les dimensions sont identiques tant que les variations dimensionnelles restent dans la gamme des variations liées aux déviations du procédé de réalisation. Ainsi, les paramètres étant identiques, il est plus facile de modéliser le fonctionnement de la structure et il est également plus facile de former la structure, par exemple les effets de charge des différents procédés sont identiques et donc les variations de tous les dispositifs seront sensiblement du même ordre de grandeur.

Le premier jeu de transistors formé par le premier transistor de conduction 2a et le premier transistor d'accès 1a est en regard du second jeu de transistors formé par le second transistor de conduction 2b et le second transistor d'accès 1b. Il en va donc de même des première et seconde zones actives dans la mesure où elles ont la même longueur et elles comportent chacune un jeu de transistors.

Avantageusement, l'axe AA' qui relie le contact 8 de source/drain connecté à une ligne de Bit BL d'une première zone active et le contact 8 de source/drain connecté à un potentiel prédéterminé, ici la masse GND, est parallèle à l'axe longitudinal BB' des électrodes de grille 6, 7. Ceci permet d'avoir une cellule mémoire très compact car il y a réduction des marges de sécurité. De même, il est avantageux que l'axe longitudinal des zones actives 5 soit perpendiculaire aux axes AA' et BB'.

Les premier et second jeux de transistors sont disposés tête-bêche, c'est-à-dire que l'alignement des transistors de conduction et d'accès est inversé. Ainsi, le premier transistor d'accès 1 a est en vis-à-vis du second transistor de conduction 2b et le premier transistor de conduction 2a est en vis-à-vis du second transistor d'accès 1b. Le vis-à-vis est réalisé selon l'axe BB'. La connexion des transistors d'accès et de conduction respectivement aux lignes de Bit et à la masse GND ou la tension Vdd n'est pas remise en cause. Cette organisation tête-bêche des deux jeux de transistors permet de gagner en compacité dans la cellule mémoire comparée à la cellule de l'art antérieur. En d'autres termes, au regard d'un plan FS perpendiculaire au substrat passant par les premier F et second S noeuds électriques, le premier transistor d'accès 1 a et le second transistor de conduction 2b sont d'un premier coté de ce plan alors que le second transistor d'accès 1 b et le premier transistor de conduction sont de l'autre coté de ce plan FS. Avantageusement, les connexions de la contre-électrode 4 et de l'électrode de grille 7 associée sont disposées de part et d'autre dudit plan FS afin de conserver une structure compacte.

En effet, un transistor de conduction 2 est associé à une contre-électrode 4 et cette contre-électrode 4 doit présenter une partie en saillie afin de faciliter la prise de contact avec une électrode de grille. Pour éviter les problèmes de court-circuit entre les contre-électrodes 4, il est important de respecter des marges de sécurité dans les dessins des différentes électrodes. Dans l'architecture de l'art antérieur les marges de sécurité L s'additionnent afin d'assurer la connexion entre l'électrode de grille du transistor de conduction 2 et sa contre-électrode associée pour éviter les courts-circuits. Il existe également des marges de sécurité M à prendre en compte pour éviter le court-circuit entre l'électrode de grille 7 du transistor de conduction et les contacts 8 de source/drain associé à ce transistor. En revanche, en mettant en vis-à-vis un transistor de conduction 2 avec un transistor d'accès 1, les marges de sécurité entre l'électrode de grille et le contact de source/drain et les marges de sécurité entre les deux contre-électrodes ne s'additionnent pas.

Chaque transistor comporte une électrode de grille 6, 7 dont une première partie, la partie étroite sert à définir la longueur du canal de conduction dans la couche en matériau semi-conducteur et dont une seconde partie la partie large sert à positionner le contact de grille (figure 4). Ainsi, il est possible d'utiliser un contact de grille qui est plus large que la longueur du canal de conduction. Cependant, dans des cas particuliers, seule la partie étroite de la grille 7 est formée pour les transistors de conduction (figure 5). Ce cas de figure particulier peut également être envisagée pour les transistors d'accès.

Dans un mode de réalisation privilégié illustré aux figures 4 et 5, les contacts 9 de grille du premier transistor d'accès 1 a et du second transistor de conduction 2b sont orientés suivant une première direction latérale, c'est-à-dire que les têtes de grille, les parties larges de grilles ou une partie qui contient les contacts 9 sont positionnées toutes les deux d'un même coté de leur zone active respective (par rapport à l'axe longitudinal de la zone active), par exemple à gauche de la zone active correspondante. A l'inverse, les contacts 9 de grille du second transistor d'accès et du premier transistor de conduction sont orientés suivant une second direction latérale qui est opposée à la première direction latérale, c'est-à-dire que les têtes de grille, sont positionnées d'un même coté de leur zone active respective, par exemple à droite de la zone active correspondante. Il en ressort que les têtes de grilles des transistors de conduction 2 ou les têtes de grilles des transistors d'accès 1 sont formées entre les deux zones actives 5. De manière très avantageuse, les têtes de grille des transistors de conduction 2 sont localisées entre les zones actives ce qui permet de réduire la surface de la cellule mémoire. Lorsqu'il n'existe pas de tête de grille large pour une électrode de grille 7, la majeure partie de l'électrode de grille d'un transistor de conduction est formée entre les deux zones actives. En d'autres termes, les contacts d'électrode de grille du transistor de conduction 2 et du transistor d'accès 1 d'une même zone active 5 sont disposés de part et d'autre de leur zone active 5.

De manière également avantageuse, les électrodes de grille du premier transistor d'accès 1 a et du second transistor de conduction 2b sont alignées. De manière analogue, les électrodes de grille du second transistor d'accès 1b et du premier transistor de conduction 2a sont également alignées (figures 4 et 5). Les axes longitudinaux sont confondus donc alignés pour les transistors de conduction et d'accès en vis-à-vis.

Tous les transistors sont des transistors avec une électrode en face arrière, c'est-à-dire des transistors qui comportent chacun deux électrodes de grille en plus de première et seconde électrodes de source/drain et d'un canal de conduction. De manière classique, les deux électrodes de grille sont disposées de part et d'autre du canal de conduction et définissent deux faces opposées du canal de conduction. Les électrodes de grille sont séparées du canal de conduction par un matériau électriquement isolant. La première électrode de grille est formée par un matériau de grille qui est déposé sur la couche en matériau semi-conducteur et qui est séparée de cette couche en matériau semi-conducteur par un diélectrique de grille. La seconde électrode de grille est formée par une portion du substrat de support qui est séparée de la couche en matériau semi-conducteur par la couche en matériau d'isolation. Les matériaux électriquement isolants qui séparent le canal (d'une manière générale la zone active) d'une électrode de grille ou d'une contre-électrode de grille peuvent être identiques mais aussi différents en composition et/ou en épaisseur. La seconde électrode de grille est communément appelée contre-électrode. La contre-électrode est formée de manière conventionnelle dans le substrat de support, par exemple par dopage d'une partie du substrat de support ou au moyen d'un métal. La surface de la contre-électrode correspond sensiblement à celle de la zone active associée, mais elle peut être plus large ou plus étroite, comme plus longue ou plus courte. Il est cependant nécessaire qu'elle soit au moins en vis-à-vis des canaux de conduction des transistors afin d'avoir un effet électrostatique. Selon l'épaisseur du matériau semi-conducteur contenant la zone active 5, la seconde électrode (la contre-électrode) peut ne pas permettre la création d'un second canal. La contre-électrode permet seulement de moduler le contrôle électrostatique de la grille et ainsi la tension de seuil du transistor.

Dans la cellule mémoire, les contre-électrodes du premier transistor d'accès et du premier transistor de conduction sont communes. Il est donc suffisant de former une seule contre-électrode pour ces deux transistors et une seule prise de contact de contre-électrode. Il en va de même des seconds transistors d'accès et de conduction qui ne nécessitent qu'une seule contre-électrode et une seule prise de contact de contre-électrode. Cette prise de contact est avantageusement localisée à proximité immédiate du contact de grille du transistor de conduction associé afin de former la cellule mémoire désirée avec un maximum de compacité. Avantageusement, la surface de la contre-électrode est identique à celle de la zone active et en regard de sorte que dans une vue de dessus, aucun des deux dessins ne dépasse de l'autre.

La première électrode de grille et la contre-électrode de chaque transistor de conduction sont connectées électriquement entre elles de sorte qu'elles subissent le même signal et donc le même potentiel. Pour ce qui est des transistors d'accès, la première électrode de grille et la contre-électrode sont dissociées électriquement.

Afin d'obtenir une cellule compacte, un seul contact 9 vertical, c'est-à-dire un via, réalise la connexion électrique entre l'électrode de grille 7 du transistor de conduction et sa contre-électrode 4. En plaçant les transistors d'accès 1 et de conduction 2 tête-bêche entre les première et seconde zones actives 5, les contacts de grille se retrouvent de part et d'autre d'un axe qui passe par les deux électrodes de source/drain commune de chaque jeu de transistors. Ainsi, pour former la cellule mémoire recherchée, il n'est plus nécessaire d'utiliser deux niveaux d'interconnexion métallique pour former la cellule mémoire un seul niveau d'interconnexion métallique est suffisant. Les connexions de la contre-électrode 4 et de l'électrode de grille 5 du transistor de conduction associé sont disposées de part et d'autre du plan SF.

Comme illustré aux figures 4 et 5, le contact 9 de grille du second transistor de conduction 2b est disposé dans la partie supérieure de la cellule mémoire, c'est-à-dire au dessus du plan SF. La connexion du contact de grille au noeud électrique opposé (le premier noeud électrique) peut alors être réalisé sans traverser le plan SF. De manière analogue, le contact de grille du premier transistor de conduction est disposé dans la partie inférieure de la cellule mémoire, c'est-à-dire au dessous du plan SF. Il est alors possible de relier les deux noeuds électriques à leur contact de grille respectif (ceux de l'autre zone active) dans le même niveau d'interconnexion métallique, de préférence de manière symétrique.

Cette architecture permet d'obtenir une cellule symétrique ce qui est un élément favorable pour l'obtention d'un circuit plus robuste et plus stable, notamment en ce qui concerne la maîtrise des capacités parasites.

Différentes variantes de réalisations sont envisageables afin d'obtenir la mise à disposition du contact de contre-électrode de manière simple et compacte. Dans une première variante de réalisation, le contact 9 de grille présente une surface plus importante que la tête de grille du transistor de conduction. En éliminant et en protégeant la couche en matériau semi-conducteur et la couche d'isolation à proximité immédiate de la tête de grille, il est possible de réaliser un contact 9 électrique commun entre la contre-électrode et l'électrode de grille associée. Il est alors avantageux d'utiliser un contact 9 de grille qui présente une surface plus importante pour le transistor de conduction 2 que pour le transistor d'accès 1 (figure 4).

Dans une seconde variante de réalisation, le contact 9 de grille est réalisé à travers la tête de grille ce qui se traduit par l'existence d'un contact 9 électrique vertical direct entre la tête de grille et la contre-électrode.

Dans une troisième variante de réalisation, une prise de contact de contre-électrode est réalisée à la périphérie de la zone active. Cette prise de contact de contre-électrode est réalisée sur toute la hauteur de la couche d'isolation et de la couche en matériau semi-conducteur de manière à autoriser un contact commun avec la contre-électrode au moyen d'un via métallique qui recouvre la tête de grille et la prise de contact de grille.

Dans toutes les variantes précédentes, il est possible de réaliser une pluralité de cellules mémoire sur un même substrat. Les différentes cellules mémoires ayant un fonctionnement indépendant, il est primordial d'assurer l'intégrité électrique de chacune des cellules par rapport aux autres. Lorsque la contre-électrode est formée par dopage du substrat de support en matériau semi-conducteur, le motif d'isolation qui sépare les zones actives 5 sépare également les contre-électrodes. De ce fait, l'épaisseur de la zone dopée dans le substrat de support est inférieure à l'enfoncement du motif d'isolation dans le substrat de support.

La contre-électrode est réalisée en dopant le substrat de support de manière opposée au dopage existant dans le substrat. Ainsi, si le substrat est de type P, les contre-électrodes sont formées par des zones dopées de type N, ou inversement. Il se forme alors une jonction de type P/N ou P/N entre la contre-électrode et le substrat. Il est également envisageable de former deux zones de dopages opposées dans le substrat. La première zone dopée forme la contre-électrode et la deuxième zone dopée isole électriquement la contre-électrode du substrat au moyen d'une jonction P/N ou N/P. Avantageusement, la zone présentant un dopage de type opposé à celui de la contre-électrode est polarisée de manière à ce que la diode soit polarisée en inverse. Par exemple, une contre-électrode dopée de type P+ est associée à une caisson de type N qui est polarisé à la tension Vdd. Ce mode de réalisation est avantageux car toutes les contre-électrodes peuvent être réalisées au moyen du même type de dopage.

Il est encore plus avantageux de former la contre-électrode avec le même type de dopage que la zone active afin d'assurer une très bonne conduction électrique et une grande compacité de la structure liée à une absence de niveau de photolithographie spécifique. De cette manière, les première et seconde contre-électrodes 4 formées dans des zones de substrat de support dopées par un premier type de dopant sont séparées l'une de l'autre et du reste du substrat de support par une zone dopée d'un type de dopage opposé. Ainsi, les première et seconde contre-électrodes 4 en substrat de support dopé par un premier type de dopant sont séparées l'une de l'autre et du reste du substrat de support par une zone dopée d'un type de dopage opposé.

Dans une quatrième variante, deux cellules mémoires sont intégrées. Dans cette architecture particulière, la première zone active en matériau semi-conducteur présente une longueur différente de la seconde zone active. La première et la seconde zones actives sont complétées par une troisième zone active. La troisième zone active est dans le prolongement de la seconde zone active et en regard de la première zone active. Le dispositif formé par les deux cellules mémoires correspond sensiblement à la répétition de la première cellule mémoire par rapport à un plan de symétrie qui est perpendiculaire à la surface de la couche en matériau semi-conducteur et perpendiculaire à l'axe longitudinal des zones actives. La première zone active est prolongée sans coupure et comporte alors deux transistors de conduction et deux transistors d'accès. La seconde zone active est transformée en la troisième zone active. Il est également possible de former un dispositif mémoire qui comporte une première zone en matériau semi-conducteur 5a munie d'une pluralité de transistors de conduction et de transistors d'accès.

Dans la première zone active, selon la configuration, les transistors d'accès sont localisés aux extrémités de la zone active et les transistors de conductions sont localisés au centre ou inversement. Bien que ces quatre transistors soient tous associés à une même zone active, une contre-électrode ne peut être associée à plus d'un transistor d'accès et un transistor de conduction. Il y a donc deux contre-électrodes adjacentes disposées sous la première zone active. Il y a également une contre-électrode disposée sous la seconde zone active et une contre-électrode disposée sous la troisième zone active. Chaque contre-électrode est associée à la grille du transistor de conduction correspondant. L'arrangement des transistors entre eux est analogue à ce qui a été décrit précédemment afin de former deux cellules mémoires indépendantes.

Bien entendu, les deux contre-électrodes formées en face de la même zone active et associées à deux cellules mémoires différentes sont dissociées électriquement. Cette dissociation peut être réalisée par toute technique adaptée, par exemple en s'assurant qu'une zone de dopage opposé existe entre ces deux contre-électrodes ou en intégrant un motif d'isolation additionnel sous la zone active entre les deux contre-électrodes.

Dans encore une autre variante, les première et seconde cellules mémoires sont réalisées au moyen des première et seconde zones actives en réalisant la même répétition que précédemment par un plan de symétrie. Dans ce mode de réalisation il n'y a pas formation d'une troisième zone active mais prolongement de la seconde zone active. De manière analogue, il est possible de former un dispositif mémoire comprenant une pluralité de cellules mémoires en répétant la structure avec une symétrie par un plan comme expliqué précédemment. Avantageusement, le plan de symétrie est disposé sur le contact de source/drain associé à une Bit line et/ou sur le contact de source/drain associé à la masse ou la tension Vdd (plan contenant l'axe AA') afin d'être plus compact.

La formation d'un dispositif mémoire au moyen d'une matrice de cellules mémoires peut également être réalisée en répétant la cellule de base selon une direction perpendiculaire, toujours selon une symétrie par plan. Là encore, il est avantageux de placer le plan de symétrie sur le contact de grille du transistor d'accès si ce dernier est disposé à l'extérieur de l'espace inter zone active de la cellule mémoire élémentaire.

Dans un mode de réalisation privilégié, il existe un axe de symétrie vertical, c'est-à-dire perpendiculaire à la surface du substrat de support, pour toute la cellule ou pour une partie de la cellule. Avantageusement, il existe un axe de symétrie en ce qui concerne la première et la seconde zones actives 5 et en ce qui concerne la première et la seconde contre-électrodes. Cette symétrie permet de faciliter l'intégration des différents éléments, car elle assure une répercussion identique des différentes dérives du procédé de fabrication. Il est également particulièrement avantageux d'avoir une symétrie de la cellule mémoire car, comme expliqué plus haut, il est plus facile de modéliser son fonctionnement.

Lorsque les cellules mémoires sont intégrées en matrice, le caisson de dopants recouvre avantageusement toute la matrice afin d'isoler électriquement les contre-électrodes. De cette manière, les contre-électrodes sont isolées les unes des autres et elles sont isolées du reste du substrat (de l'environnement extérieur).

## Revendications

1. Cellule mémoire de type SRAM à quatre transistors munis d'une contre-électrode comportant :
- une première zone en matériau semi-conducteur (5a) avec un premier transistor d'accès (1a) et un premier transistor de conduction (2a) connectés en série, leur borne commune définissant un premier noeud électrique (F),
- une seconde zone en matériau semi-conducteur (5b) avec un second transistor d'accès (1b) et un second transistor de conduction (2b) connectés en série, leur borne commune définissant un second noeud électrique (S),
- un substrat de support, avec des première et seconde contre-électrodes (4), les première et seconde contre-électrodes (4) étant respectivement en vis-à-vis des première et seconde zones en matériau semi-conducteur (5),
cellule mémoire **caractérisée en ce que** le premier transistor d'accès (1a) et le second transistor de conduction (2b) sont d'un premier coté d'un plan (FS) passant par les premier (F) et second (S) noeuds électriques et **en ce que** le premier transistor de conduction (2a) et le second transistor d'accès (1 b) sont de l'autre coté dudit plan (FS) et **en ce que** les connexions de la contre-électrode (4) et de l'électrode de grille associée sont disposées de part et d'autre dudit plan (FS).

2. Cellule selon la revendication 1 **caractérisée en ce que** des contacts d'électrode de grille du transistor de conduction (2) et du transistor d'accès (1) sont disposés de part et d'autre de leur zone active (5).

3. Cellule selon l'une des revendications 1 et 2 **caractérisée en ce que** la première zone en matériau semi-conducteur (5a) présente une largeur différente entre le transistor de conduction (2a) et le transistor d'accès (1 a).

4. Cellule selon la revendication 3 **caractérisée en ce que**, la première zone en matériau semi-conducteur (5a) présente un décroché au niveau de ses parois longitudinales.

5. Cellule selon l'une quelconque des revendications 1 à 4 **caractérisée en ce que** l'axe longitudinal de l'électrode de grille du premier transistor d'accès (1a) est aligné avec l'axe longitudinal de l'électrode de grille du second transistor de conduction (2b).

6. Cellule selon la revendication 5 **caractérisée en ce que** l'axe longitudinal de l'électrode de grille du second transistor d'accès (1 b) est aligné avec l'axe longitudinal de l'électrode de grille du premier transistor de conduction (2a).

7. Cellule selon l'une quelconque des revendications 1 à 6, **caractérisée en ce que** le contact (9) de grille du transistor de conduction (2) présente une surface supérieure au contact (9) de grille du transistor d'accès (1).

8. Cellule selon l'une quelconque des revendications 1 à 7, **caractérisée en ce qu'**elle comporte un axe de symétrie entre les première (5a) et seconde (5b) zones en matériau semi-conducteur et les première (4a) et seconde (4b) contre-électrodes.

9. Cellule selon l'une quelconque des revendications 1 à 8, **caractérisée en ce que** les première et seconde contre-électrodes (4) en substrat de support dopé par un premier type de dopant sont séparées l'une de l'autre et du reste du substrat de support par une zone dopée d'un type de dopage opposé.

10. Dispositif mémoire incorporant une cellule selon l'une quelconque des revendications 1 à 8, **caractérisé en ce que** la première zone en matériau semi-conducteur (5a) comporte une pluralité de transistors de conduction (2) et de transistors d'accès (1 a).
